# EUROPEAN PATENT SPECIFICATION

(11) **EP 3 551 979 B1**
(45) Date of publication and mention of the grant of the patent: **14.06.2023**
(21) Application number: 18741436.2
(22) Date of filing: 16.01.2018
(51) Int. Cl.: G01K 7/00, A62C 3/16, G01J 5/10, G01J 5/28, G01J 5/48

(54) **SYSTEMS AND METHODS FOR CONTINUOUSLY MONITORING A TEMPERATURE OF AN ELECTRICAL SUPPLY SYSTEM**
SYSTEME UND VERFAHREN ZUR KONTINUIERLICHEN ÜBERWACHUNG EINER TEMPERATUR EINES STROMVERSORGUNGSSYSTEMS
SYSTÈMES ET PROCÉDÉS DE SURVEILLANCE CONTINUE D'UNE TEMPÉRATURE DE SYSTÈME D'ALIMENTATION ÉLECTRIQUE

(30) Priority: 18.01.2017 US 201762447656 P
(43) Date of publication of application: 16.10.2019
(73) Proprietor: Starline Holdings, LLC, Canonsburg, PA 15317 (US)
(72) Inventor: SWIFT, Mark, A., Cannonsburg PA 15317 (US); GRAFTON, David, S., Canonnsburg PA 15317 (US)
(74) Representative: Pons
(86) International application number: PCT/US2018/013860
(87) International publication number: WO 2018/136414

(56) References cited:
- EP-A1- 2 939 414
- CN-A- 102 169 017
- US-A1- 2009 115 427
- US-A1- 2014 168 433
- US-A1- 2014 168 433
- US-A1- 2015 286 225
- US-B2- 8 324 907

## Description

### CROSS-REFERENCE TO RELATED APPLICATION

The present application claims priority to United States Provisional Patent Application Serial No. 62/447656, filed January 18, 2017 and entitled "Systems and Methods for Continuously Monitoring a Temperature of An Electrical Supply System".

### TECHNICAL FIELD

The present specification generally relates to sensing devices that are particularly configured to detect potentials for failure in a busway or other electrical supply system.

### BACKGROUND

A technician is required to physically travel to the location of a conventional electrical supply system to monitor various current and temperatures. More specifically, the technician may employ a monitoring device such as a handheld scanner to monitor the current and temperature of the electrical supply system. As such, the electrical supply system cannot be continuously monitored and requires the technician to be physically present. As a result, failures may occur within the electrical supply system between periods when the technician inspects the system

Increased temperatures or decreased temperatures within the electrical supply system may be caused by electrical components such as, but not limited to, fraying wires, power surges, component failure, and/or the like. In one example, an electrical supply system may employ terminal lugs to connect an electrical cable to an electric bus conductor, in which the terminal lugs are held to the electric bus connector. However, because of various features that enable a terminal lug to connect to the electric cable to the electric bus conductor such as screws, clamps, clips, and/or the like, the terminal lugs may be subject to loosening over time. When a terminal lug becomes loose, a resistance may increase within the terminal lug, which results a generation of thermal energy. The generated thermal energy may increase the overall temperature in various portions of the electrical supply system, which may affect the functionality of the electrical supply system.

US8324907 B2 discloses a method of monitoring an electrical connection.

### SUMMARY

There is a need for continuously monitoring current and temperatures in electrical supply systems, as well as components thereof, such that a current and/or a temperature outside a threshold (e.g., below or above a particular rated current and/or below or above a particular temperature) can be determined and addressed before a failure results therefrom. Existing monitoring methods require a technician to physically travel to the location of an electrical supply system and use a handheld scanner to check for issues. As such, the electrical supply system cannot be continuously monitored, which may result in failures that occur between periods when a technician is on site.

The invention is defined in the appended claims.

### BRIEF DESCRIPTION OF THE DRAWINGS

The embodiments set forth in the drawings are illustrative and exemplary in nature and not intended to limit the subject matter defined by the claims. The following detailed description of the illustrative embodiments can be understood when read in conjunction with the following drawings, where like structure is indicated with like reference numerals and in which:
FIG. 1 depicts a schematic illustration of a power monitoring system according to one or more embodiments shown and described herein;
FIG. 2 depicts an exemplary process flow diagram of the power monitoring system operating to monitor an electrical supply system according to one or more embodiments shown and described herein; and
FIG. 3 depicts an exemplary metering unit that is included with the power monitoring system shown in FIG. 1.

### DETAILED DESCRIPTION

The embodiments described herein are generally directed to systems and methods for continuous monitoring of electrical supply systems or components thereof for current and/or temperature fluctuations. The systems and methods may generally include an infrared (IR) sensor, a temperature sensor, and a current sensor. The various sensors that are positioned at various locations such that they sense a temperature of particular components of an electrical supply system and/or a current passing through such particular components, such as terminal lugs, busbar joints, and/or the like. If the temperature of the components of the electrical supply system moves outside a threshold (e.g., moves above or below a threshold), the components may be more susceptible to failure. Alternatively, or in addition, if the temperature trends relative to the current (e.g., surpassing a threshold while 80% of the rated current is flowing would not be the equivalent of surpassing the threshold while 20% of the rated current is flowing), the component may be more susceptible to failure. As such, various sensors may continuously monitor such components and provide an alert when the temperature rises above the threshold (or above the threshold relative when the current is at a particular level) such that other actions may be taken to avoid failure.

In various embodiments, the monitoring systems and methods described herein may be positioned adjacent to electrical supply systems and/or particular components thereof in order to effectively monitor the temperatures and/or current of the electrical supply systems and/or components thereof. In some embodiments, the monitoring systems and methods described herein may be integrated within other electrical supply monitoring systems, such as, for example, the STARLINE Critical Power Monitor (CPM) system that may be integrated with, for example, the STARLINE Track Busway System (Universal Electric Corporation, Canonsburg PA)..

Users of systems such as the STARLINE Track Busway System as described above may periodically need to scan the feeds thereof to determine if a potential failure may be looming in the future. As terminal lugs become loose over time, resistance increases in these lugs, thereby causing elevated temperatures. If this is not detected within a reasonable amount of time, a failure can occur. Due to the criticality of the equipment that is typically powered by such an electrical supply system, it is necessary to continuously monitor the electrical supply systems such that increases in temperature above the threshold (and potentially relative to the current passing through the systems) are discovered immediately so corrective action can be taken.

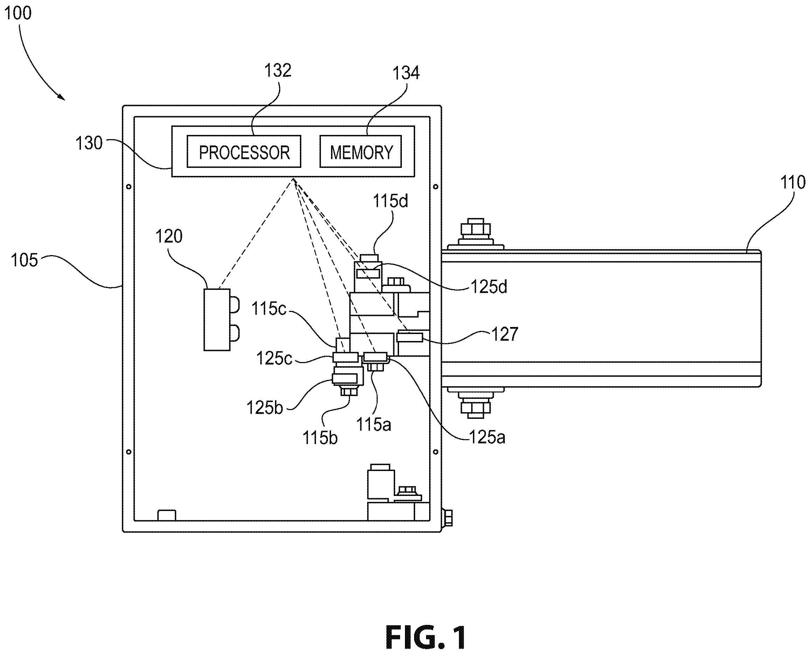

FIG. 1 depicts an illustrative metering system, generally designated 100, that is integrated with an electrical supply system. For example, the metering system 100 may include a feed unit 105 that is coupled to a busway 110 of an electrical supply system. However, such a location is merely illustrative, and it should be understood that the metering system 100 may be located relative to other components of an electrical supply system without departing from the scope of the present disclosure. It should be appreciated that the feed unit 105 is shown without a cover for illustrative purposes only and the busway should be enclosed.

The feed unit 105 may be a housing or the like that houses the various components described herein, as well as other components that may be included as a component of various additional monitoring devices, electrical supply devices, and/or the like. The feed unit 105 may be located at various locations within a busway system, including end feeds, center feeds, and top and bottom feeds. These feeds contain terminal lugs for landing feed wires from an upstream power source. Periodically, these lugs need to be examined for tightness, appropriate torque, increased heat, and potential signs of failure.

In the embodiment depicted in FIG. 1, the feed unit 105 may include a plurality of terminal lugs 115a-115d (collectively 115). While FIG. 1 depicts four terminal lugs 115a-115d, the present disclosure is not limited to such. That is, in various embodiments, a feed unit 105 may include a single terminal lug 115, less than four terminal lugs 115, or greater than 4 terminal lugs 115.

As should generally be understood, the terminal lugs 115 may generally be provided for connecting an electric cable to an electric bus conductor in which the terminal lugs 115 are held to the electric bus conductor. Because of the various designs of terminal lugs 115 that allow them to connect the electric cable to the electric bus conductor (e.g., screws, clamps, clips, etc.), the terminal lugs 115 may be subject to loosening over a period of time. For example, vibrations caused by the electrical current passing through the various components may cause the terminal lugs 115 to become loose. When a terminal lug 115 becomes loose, a resistance may increase in the terminal lugs 115, which in turn generates thermal energy. The generated thermal energy may increase the overall temperature in various portions of the electrical supply system, which can be detrimental to the functionality of the electrical supply system by damaging components, rendering certain components ineffective or less effective, and/or the like. In some embodiments, the increased temperature can cause component failure. Component failure may result in, for example, a lack of power delivery, damage to components connected to the electrical supply system, and/or the like. As such, a need exists to ensure that increased temperatures are addressed as soon as possible after the increased temperatures occur.

It should be understood that while the present disclosure specifically describes increased temperatures that are caused by loose terminal lugs 115, the present disclosure is not limited to such. That is, increased temperatures (or decreased temperatures) may be caused by other electrical supply components, including, but not limited to, fraying wires, power surges, component failure, and/or the like. As such, the present systems and methods may be used to monitor the temperature of and current through any component of an electrical supply system without departing from the scope of the present disclosure. For example, the present systems and methods may be used to monitor current and/or temperature for busbar joints and/or the like.

Accordingly, to effectively monitor the various components of an electrical supply system, the metering system 100 may include one or more infrared sensors 120, and/or one or more temperature sensors 125a-125d (collectively 125), and one or more current sensors 127. That is, in some embodiments, the metering system 100 may include one or more infrared sensors 120, one or more temperature sensors 125, and one or more current sensors 127. In other embodiments, the metering system 100 may include one or more current sensors 127, as well as one or more infrared sensors 120 or one or more temperature sensors 125.

The one or more infrared sensors 120 may be positioned at a location such that the infrared sensors 120 can detect an amount of thermal energy emitted from one or more target components of the electrical supply system (e.g., one or more of the terminal lugs 115) and transmit temperature data to a central computing device 130 communicatively coupled thereto (e.g., coupled via wired communication, wireless communication, etc.). As such, the one or more infrared sensors 120 may be positioned within a vicinity of one or more target components of an electrical supply system, such as, for example, one or more of the terminal lugs 115. In some embodiments, one or more target components of the electrical supply system may be positioned within a field of view (FOV) of the one or more infrared sensors 120.

The one or more infrared sensors 120 are not limited by this disclosure, and may generally include any type of infrared sensor or infrared sensor technology now known or later developed such as, for example, infrared cameras. In some embodiments, the one or more infrared sensors 120 may be components that are particularly adapted for continuously monitoring components and relaying temperature data. For example, the one or more infrared sensors 120 may transmit image data (e.g., .jpg, .png, .prn format files or the like) that correspond to sensed information obtained by the infrared sensors 120.

Similarly, the one or more temperature sensors 125 may be positioned at a location such that the temperature sensors 125 can detect an amount of thermal energy emitted from one or more target components of the electrical supply system (e.g., one or more of the terminal lugs 115) and transmit temperature data to the central computing device 130 communicatively coupled thereto. As such, the one or more temperature sensors 125 may be positioned within a vicinity of one or more target components of an electrical supply system, such as, for example, one or more of the terminal lugs 115. In some embodiments, the temperature sensors 125 may be positioned such that the temperature sensors 125 are physically contacting (e.g., disposed on) one or more target components such that the temperature sensors 125 can appropriately sense the temperature of the one or more target components. In some embodiments, the temperature sensors 125 may be positioned in-line with the various components of the electrical supply system (e.g., such that the component passes through the temperature sensors 125 and/or such that the temperature sensors 125 are integrated with joints of the electrical supply system (joint between busway sections)).

The one or more temperature sensors 125 are not limited by this disclosure, and may generally include any type of temperature sensor or temperature sensing technology now known or later developed. In some embodiments, the one or more temperature sensors 125 may be components that are particularly adapted for continuously monitoring components and relaying temperature data. Illustrative examples of temperature sensors include, but are not limited to, resistance temperature devices (RTDs), bimetallic detectors, thermistors, and thermocouplers.

The one or more current sensors 127 may be positioned at a location such that the current sensors 127 can detect an amount of current passing through one or more target components of the electrical supply system (e.g., one or more of the terminal lugs 115) and transmit current data to a central computing device 130 communicatively coupled thereto (e.g., coupled via wired communication, wireless communication, etc.). As such, the one or more current sensors 127 may be positioned within a vicinity of one or more target components of an electrical supply system, such as, for example, one or more of the terminal lugs 115. In some embodiments, the current sensors 127 may be positioned such that the current sensors 127 are physically contacting (e.g., disposed on) one or more target components such that the current sensors 127 can appropriately sense the current passing through the one or more target components. In some embodiments, current sensors 127 may be positioned in-line with the various components of the electrical supply system (e.g., such that a component passes through the current sensor 127 and/or such that the current sensors 127 are located on a joint of the electrical supply system (joint between busway sections)).

The one or more current sensors 127 are not limited by this disclosure, and may generally include any type of current sensor or current sensor technology now known or later developed. For example, the one or more current sensors 127 may incorporate a Hall effect sensor, a transformer or current clamp, a fluxgate transformer, a resistor, a Rogowski coil, or the like. In some embodiments, the one or more current sensors 127 may be components that are particularly adapted for continuously monitoring components and relaying current data. For example, the one or more current sensors 127 may transmit a signal that is proportional to the amount of electric current passing through a component, such as an analog voltage signal or a digital output.

The central computing device 130 may generally be a computing device that is particularly adapted to control the one or more infrared sensors 120, the one or more temperature sensors 125, and the one or more current sensors 127, receive temperature and current data from the various sensors, determine whether the temperature data moves outside a particular threshold, determine a current passing through a particular object, determine a rated current for a particular object, and complete additional steps in response to the determination. The threshold may be, for example, a temperature value which is considered outside a normal operating range for a particular component, which is based on the current passing therethrough and the current rating for that particular component. That is, in some embodiments, the threshold may be a temperature value that is high enough or low enough to cause damage to a particular component. Illustrative thresholds should generally be understood, such as thresholds established by various safety organizations. For example, the temperature threshold may be established based on various factors included within the UL 857 safety standard (Underwriters Laboratories, Northbrook IL).

Illustrative additional steps that may be completed by the central computing device 130 may include, but are not limited to, transmitting an alert or a warning to an external device (e.g., an external computing device, mobile device, or the like), completing an action to decrease the temperature (such as, for example, directing electrical flow through an alternative circuit until the cause of the temperature increase/decrease manually determined, corrected, etc.), and/or the like.

The central computing device 130 may be a general purpose computing device or may be a particular computing device that is particularly adapted to complete the various processes described herein, and may include may include a processor 132 or any device capable of executing machine-readable instructions stored on a non-transitory computer-readable medium. As such, the central computing device 130 may contain various components including (but not limited to) a processing device 132, a non-transitory, processor readable storage medium (e.g., a memory 134), various communication devices/ports for communicating with the infrared sensors 120, temperature sensors 125, current sensors 127 and/or external devices, a user interface, and/or the like. Accordingly, each of the one or more processors 132 may include a controller, an integrated circuit, a microchip, a computer, and/or any other computing device.

Other components of the central computing device 130 not specifically described herein may also be included without departing from the scope of the present disclosure.

In some embodiments, the central computing device 130 may be integrated as a daughter card or the like into an existing computing device, such as, for example, an existing computing device that is used for sensing various other properties and/or conducting other tasks related to electrical supply system monitoring.

In various embodiments, a method of continuously monitoring an electrical supply with the one or more infrared sensors 120, the one or more temperature sensors 125, and/or the one or more current sensors 127 may generally include directing the one or more infrared sensors 120, the one or more temperature sensors 125, and/or the one or more current sensors 127 to sense a temperature (or a current), which may be completed continuously or at specified intervals (e.g., every hour, every several hours, daily, weekly, or the like), receiving temperature data, receiving current data, determining a relationship between the current data and a current rating, determining whether the temperature moves outside a threshold (e.g., above or below a particular temperature threshold), determining a corrective action if a temperature moves outside a threshold, transmitting an alert or the like if a temperature moves outside a threshold, directing the operation of various components to avoid a failure, providing a user interface for directing a user to a particular location where a temperature anomaly has been sensed, providing instructions to a user for correcting an error, and/or the like. It should be understood that additional steps may also be completed in response to sensing a temperature anomaly without departing from the scope of the present disclosure. For example, in some embodiments, real-time data corresponding to a sensed temperature may be provided via a user interface or to an external device, regardless of whether a temperature anomaly and/or a current anomaly has been detected. That is, if a user desires to see what the current temperature and/or current is for a particular component, he/she may be provided this information instantaneously.

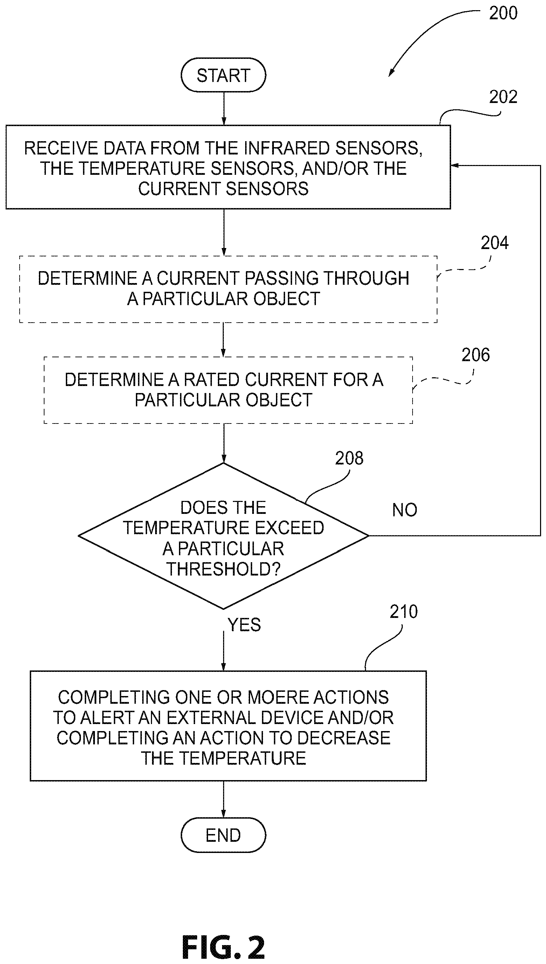

Referring now to FIG. 2, an exemplary flowchart 200 depicting a method for monitoring the various components of an electrical supply system by the disclosed metering system 100 is shown. It should be understood that embodiments are not limited by the order of steps of the flowchart 200 of FIG. 2.

Referring to both FIGS. 1 and 2, the method may begin in block 202. In block 202, the computing device 130 receives temperature and current data from the various sensors. More specifically, the computing device 130 receives temperature data from the one or more infrared sensors 120 and/or the temperature sensors 125, and receives current from the one or more current sensors 127. The method may then proceed to block 204.

In block 204, the computing device 130 determines the current passing through one or more target components based on the current data collected by the one or more current sensors 127. For example, the computing device 130 may determine the current passing through one or more of the terminal lugs 115. The method may then proceed to block 206.

In block 206, the computing device 130 determines the rated current for the target component. For example, the rated current may be stored in the memory 134 of the computing device 130. The method may then proceed to decision block 208.

In decision block 208, the computing device 130 compares the temperature data to a particular temperature threshold. The temperature threshold may be a temperature value that is high enough or low enough to cause damage to a particular component. The temperature threshold is based on the current passing therethrough and the current rating for the target component. For example, surpassing a temperature threshold of the target component while 80% of the rated current is flowing would not be the equivalent of surpassing the temperature threshold while 20% of the rated current is flowing. It should be appreciated that when a current flows through a resistor, electrical energy is converted into heat energy. There is a relationship between how much power a device may dissipate without adverse effects at any given case temperature, where higher temperatures result in a lower amount of power that may be dissipated without unwanted consequences.

In response to the computing device 130 determining that the temperature data pertaining to the target component is within the temperature threshold (e.g., within an upper or a lower limit of the temperature threshold), then the method may proceed back to block 202. In other words, if the temperature data is either below the threshold temperature value (for a maximum temperature) or above the threshold temperature (for a minimum temperature), then the method may proceed back to block 202, and the computing device 130 may continue to receive data. However, in response to determining the temperature data pertaining to the target component exceeds the threshold temperature value (for a maximum temperature) or is below the threshold temperature (for a minimum temperature), then the method may proceed to block 210.

In block 210, the computing device 130 may determine one or more corrective actions to either create a notification or to increase/decrease the temperature of the target component. For example, the notification may involve transmitting an alert or a warning to an external device (e.g., an external computing device, mobile device, or the like). In addition to or in the alternative, actions such as directing electrical flow through an alternative circuit or disconnecting the electrical circuit until the cause of the temperature increase/decrease is corrected may also be performed as well. The method may then terminate.

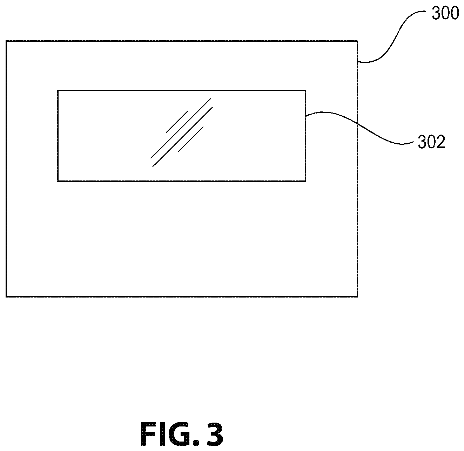

FIG. 3 depicts an illustrative meter unit 300 including a monitor 302. The meter unit 300 may be communicatively coupled to the computing device 130 shown in FIG. 1 (e.g., coupled via wired communication, wireless communication, etc.). In an embodiment, the monitor 302 is part of or is integrated with the computing device 130. The monitor 302 may be any type of screen that is configured to display images that is now known or later developed. For example, the monitor 302 may incorporate liquid crystal display (LCD) technology, light emitting diodes (LEDs), cathode ray tube technology, and the like. In some embodiments, the monitor 302 may be used as a covering for the metering system 100 in FIG. 1.

Referring to both FIGS. 1 and 3, the one or more infrared sensors 120 of the feed unit 105 comprise of one or more infrared cameras that render infrared radiation as visible light. The one or more infrared cameras may be positioned at a location such that the infrared cameras may capture thermal energy emitted from one or more target components of the electrical supply system (e.g., one or more of the terminal lugs 115) and the surrounding environment of the one or more target components. The image data generated by the infrared cameras may be received by the computing device 130. The computing device 130 may then transmit the image data to the monitor 302. The monitor 302 displays one or more thermal images that are based on the image data generated by the infrared cameras and conveys information related to the image data such as, for example, temperature of specific components. The thermal images are representative of the one or more target components and the surrounding environment (e.g., one or more of the terminal lugs 115 and the associated electric cable and electric bus conductor) based on the image data generated by the one or more image cameras. The thermal images represent electronic images that are created by the infrared radiation emitted by the various components of the feed unit 105 (e.g., the terminal lugs 115, the electric cable, the electric bus conductor, etc.).

The thermal images may be displayed as greyscale images or, alternatively, as color images. The thermal images indicate temperature gradients of the one or more target components, where lighters or brighter colors may indicate areas that are warmer, while darker areas may indicate areas that are cooler. For example, the one or more infrared cameras may transmit the thermal images in the form of image data (e.g., .jpg, .png, .prn format files or the like). In some embodiments, individuals located physically at the meter unit 300 may be able to view the thermal images and determine various hot spots or areas of the one or more target components that generated elevated or lowered temperatures. The individuals may also be able to save the thermal images to the memory 134 of the computing device 130. In some embodiments, the thermal images may be sent to a storage location on the cloud and/or may be sent to one or more email addresses.

It is noted that the terms "substantially" and "about" may be utilized herein to represent the inherent degree of uncertainty that may be attributed to any quantitative comparison, value, measurement, or other representation. These terms are also utilized herein to represent the degree by which a quantitative representation may vary from a stated reference without resulting in a change in the basic function of the subject matter at issue.

## Claims

1. - A system (100) for continuously monitoring a temperature of one or more components of an electrical supply system, the system (100) comprising:
one or more infrared or temperature sensors (120, 125) positioned to detect an amount of thermal energy emitted from the one or more target components of the electrical supply system, wherein the one or more infrared or temperature sensors (120, 125) transmit temperature data representative of the amount of thermal energy;
one or more processors (132);
one or more current sensors (127) communicatively coupled to the one or more processors, wherein the one or more current sensors are positioned to detect an amount of current passing through the one or more target components; and
one or more non-transitory memory modules (134) communicatively coupled to the one or more processors (132) and the one or more infrared sensors or temperature (120, 125) and storing machine-readable instructions that, when executed, cause the one or more processors (132) to perform at least the following:
receive the temperature data generated by the one or more infrared or temperature sensors (120, 125);
determine the amount of current passing through the one or more target components based on current data collected by the one or more current sensors (127)
determine a rated current for the one or more target components;
compare the temperature data to a particular temperature threshold, wherein the particular temperature threshold is based on the amount of current passing through the one or more target components and the rated current; and
control the one or more infrared or temperature sensors (120, 125) based on the temperature data and the particular temperature threshold.

2. - The system (100) of claim 1, wherein the machine-readable instructions further cause the one or more processors (132) to:
compare the temperature data to the particular temperature threshold; and
in response to determining that the temperature data pertaining to the one or more target components is within the particular temperature threshold, continue to receive the temperature data generated by the one or more infrared or temperature sensors (120, 125).

3. - The system (100) of claim 2, wherein the machine-readable instructions further cause the one or more processors (132) to:
in response to determining that the temperature data pertaining to the one or more target components falls outside of the particular temperature threshold, determining at least one action; and
performing the at least one action.

4. - The system (100) of claim 3, wherein the at least one action includes at least one of a corrective action, transmitting an alert, directing operation of various components, indicating a particular location where a temperature anomaly is sensed upon a user interface, and providing instructions to correct the temperature anomaly.

5. - The system (100) of claim 1, comprising:
one or more infrared sensors and one or more temperature sensors (120, 125)communicatively coupled to the one or more processors (132), wherein the one or more infrared sensors and the one or more temperature sensors (120, 125)are positioned to detect the amount of thermal energy emitted from the one or more target components of the electrical supply system.

6. - The system (100) of claim 1, further comprising:
a monitor (302) communicatively coupled to the one or more processors (132), wherein the one or more infrared or temperature sensors (120, 125) comprise one or more infrared cameras.

7. - The system (100) of claim 6, wherein the machine-readable instructions further cause the one or more processors (132) to:
receive image data generated by the one or more infrared cameras; and
display one or more thermal images representative of the one or more target components and an environment surrounding the one or more target components upon the monitor (302), wherein the one or more thermal images are based on the image data.

8. - A method of continuously monitoring a temperature of one or more components of an electrical supply system, the method comprising:
receiving the temperature data generated by one or more infrared or temperature sensors (120, 125) by a computing device (130), wherein an amount of thermal energy emitted from the one or more target components of the electrical supply system is detected by one or more infrared or temperature sensors (120, 125)
determining, by the computing device (130), the amount of current passing through the one or more target components based on current data collected by one or more current sensors (127) positioned to detect an amount of current passing through the one or more target components;
determining a rated current for the one or more target components;
comparing the temperature data to a particular temperature threshold, wherein the particular temperature threshold is based on the amount of current passing through the one or more target components and the rated current; and
controlling, by the computing device (130), the one or more infrared or temperature sensors (120, 125) based on the temperature data and the particular temperature threshold.

9. - The method of claim 8, further comprising: comparing the temperature data to the particular temperature threshold**;**
in response to determining that the temperature data pertaining to the one or more target components is within the particular temperature threshold, continuing to receive the temperature data generated by the one or more infrared or temperature sensors (120, 125); and
in response to determining that the temperature data pertaining to the one or more target components falls outside of the particular temperature threshold, determining at least one action.

## Patentansprüche

1. System (100) zum kontinuierlichen Überwachen einer Temperatur von einer oder mehreren Komponenten eines Stromversorgungssystems, wobei das System (100) Folgendes umfasst:
einen oder mehrere Infrarot- oder Temperatursensoren (120, 125), die positioniert sind, um eine Menge Wärmeenergie zu detektieren, die von der einen oder den mehreren Zielkomponenten des Stromversorgungssystems emittiert wird, wobei der eine oder die mehreren Infrarot- oder Temperatursensoren (120, 125) Temperaturdaten übertragen, die für die Menge Wärmeenergie repräsentativ sind;
einen oder mehrere Prozessoren (132);
einen oder mehrere Stromsensoren (127), die kommunikativ an den einen oder die mehreren Prozessoren gekoppelt sind, wobei der eine oder die mehreren Stromsensoren positioniert sind, um eine Menge Strom zu detektieren, die durch die eine oder die mehreren Zielkomponenten fließt; und
ein oder mehrere nichttransitorische Speichermodule (134), die kommunikativ an den einen oder die mehreren Prozessoren (132) und den einen oder die mehreren Infrarot- oder Temperatursensoren (120, 125) gekoppelt sind und maschinenlesbare Anweisungen speichern, die, wenn sie ausgeführt werden, den einen oder die mehreren Prozessoren (132) veranlassen, mindestens Folgendes durchzuführen:
Empfangen der Temperaturdaten, die von dem einen oder den mehreren Infrarot- oder Temperatursensoren (120, 125) erzeugt werden;
Bestimmen der Menge Strom, die durch die eine oder die mehreren Zielkomponenten fließt, auf Basis von Stromdaten, die von dem einen oder den mehreren Stromsensoren (127) gesammelt werden
Bestimmen eines Nennstroms für die eine oder die mehreren Zielkomponenten;
Vergleichen der Temperaturdaten mit einem bestimmten Temperaturschwellwert, wobei der bestimmte Temperaturschwellwert auf der Menge Strom, die durch die eine oder die mehreren Zielkomponenten fließt, und dem Nennstrom basiert; und
Steuern des einen oder der mehreren Infrarot- oder Temperatursensoren (120, 125) auf Basis der Temperaturdaten und des bestimmten Temperaturschwellwerts.

2. System (100) nach Anspruch 1, wobei die maschinenlesbaren Anweisungen den einen oder die mehreren Prozessoren (132) ferner zu Folgendem veranlassen:
Vergleichen der Temperaturdaten mit dem bestimmten Temperaturschwellwert; und
in Reaktion auf das Bestimmen, dass die Temperaturdaten, die zu der einen oder den mehreren Zielkomponenten gehören, innerhalb des bestimmten Temperaturschwellwerts liegen, Fortsetzen des Empfangens der Temperaturdaten, die von dem einen oder den mehreren Infrarot- oder Temperatursensoren (120, 125) erzeugt werden.

3. System (100) nach Anspruch 2, wobei die maschinenlesbaren Anweisungen den einen oder die mehreren Prozessoren (132) ferner zu Folgendem veranlassen:
in Reaktion auf das Bestimmen, dass die Temperaturdaten, die zu der einen oder den mehreren Zielkomponenten gehören, außerhalb des bestimmten Temperaturschwellwerts liegen, Bestimmen von mindestens einer Maßnahme; und
Durchführen der mindestens einen Maßnahme.

4. System (100) nach Anspruch 3, wobei die mindestens eine Maßnahme mindestens eines von einer Korrekturmaßnahme, dem Übertragen eines Alarms, dem Anweisen eines Betriebs von verschiedenen Komponenten, dem Anzeigen eines bestimmten Ortes, an dem eine Temperaturanomalie erfasst wurde, auf einer Benutzerschnittstelle und dem Bereitstellen von Anweisungen zum Korrigieren der Temperaturanomalie beinhaltet.

5. System (100) nach Anspruch 1, das Folgendes umfasst:
einen oder mehrere Infrarotsensoren und einen oder mehrere Temperatursensoren (120, 125), die kommunikativ an den einen oder die mehreren Prozessoren (132) gekoppelt sind, wobei der eine oder die mehreren Infrarotsensoren und der eine oder die mehreren Temperatursensoren (120, 125) positioniert sind, um die Menge Wärmeenergie zu detektieren, die von der einen oder den mehreren Zielkomponenten des Stromversorgungssystems emittiert wird.

6. System (100) nach Anspruch 1, das ferner Folgendes umfasst:
einen Monitor (302), der kommunikativ an den einen oder die mehreren Prozessoren (132) gekoppelt ist, wobei der eine oder die mehreren Infrarot- oder Temperatursensoren (120, 125) eine oder mehrere Infrarotkameras umfassen.

7. System (100) nach Anspruch 6, wobei die maschinenlesbaren Anweisungen den einen oder die mehreren Prozessoren (132) ferner zu Folgendem veranlassen:
Empfangen von Bilddaten, die von der einen oder den mehreren Infrarotkameras erzeugt werden; und
Anzeigen von einem oder mehreren Wärmebildern, die für die eine oder die mehreren Zielkomponenten und eine Umgebung, die die eine oder die mehreren Zielkomponenten umgibt, repräsentativ sind, auf dem Monitor (302), wobei das eine oder die mehreren Wärmebilder auf den Bilddaten basieren.

8. Verfahren zum kontinuierlichen Überwachen einer Temperatur von einer oder mehreren Komponenten eines Stromversorgungssystems, wobei das Verfahren Folgendes umfasst:
Empfangen der Temperaturdaten, die von dem einen oder den mehreren Infrarot- oder Temperatursensoren (120, 125) erzeugt werden, durch eine Datenverarbeitungsvorrichtung (130), wobei eine Menge Wärmeenergie, die von der einen oder den mehreren Zielkomponenten des Stromversorgungssystems emittiert wird, von einem oder mehreren Infrarot- oder Temperatursensoren (120, 125) detektiert wird
Bestimmen der Menge Strom, die durch die eine oder die mehreren Zielkomponenten fließt, durch die Datenverarbeitungsvorrichtung (130) auf Basis von Stromdaten, die von einem oder mehreren Stromsensoren (127) gesammelt werden, die positioniert sind, um eine Menge Strom zu detektieren, die durch die eine oder die mehreren Zielkomponenten fließt;
Bestimmen eines Nennstroms für die eine oder die mehreren Zielkomponenten; Vergleichen der Temperaturdaten mit einem bestimmten Temperaturschwellwert, wobei der bestimmte Temperaturschwellwert auf der Menge Strom, die durch die eine oder die mehreren Zielkomponenten fließt, und dem Nennstrom basiert; und
Steuern des einen oder der mehreren Infrarot- oder Temperatursensoren (120, 125) durch die Datenverarbeitungsvorrichtung (130) auf Basis der Temperaturdaten und des bestimmten Temperaturschwellwerts.

9. Verfahren nach Anspruch 8, das ferner Folgendes umfasst:
Vergleichen der Temperaturdaten mit dem bestimmten Temperaturschwellwert;
in Reaktion auf das Bestimmen, dass die Temperaturdaten, die zu der einen oder den mehreren Zielkomponenten gehören, innerhalb des bestimmten Temperaturschwellwerts liegen, Fortsetzen des Empfangens der Temperaturdaten, die von dem einen oder den mehreren Infrarot- oder Temperatursensoren (120, 125) erzeugt werden; und
in Reaktion auf das Bestimmen, dass die Temperaturdaten, die zu der einen oder den mehreren Zielkomponenten gehören, außerhalb des bestimmten Temperaturschwellwerts liegen, Bestimmen von mindestens einer Maßnahme.

## Revendications

1. Système (100) de surveillance continue d'une température d'un ou plusieurs composants d'un système d'alimentation électrique, le système (100) comprenant :
un ou plusieurs capteurs infrarouges ou de température (120, 125) positionnés pour détecter une quantité d'énergie thermique émise par les un ou plusieurs composants cibles du système d'alimentation électrique, dans lequel les un ou plusieurs capteurs infrarouges ou de température (120, 125) transmettent des données de température représentatives de la quantité d'énergie thermique ;
un ou plusieurs processeurs (132) ;
un ou plusieurs capteurs de courant (127) couplés en communication aux un ou plusieurs processeurs, dans lequel les un ou plusieurs capteurs de courant sont positionnés pour détecter une quantité de courant traversant les un ou plusieurs composants cibles ; et
un ou plusieurs modules de mémoire non transitoires (134) couplés en communication aux un ou plusieurs processeurs (132) et aux un ou plusieurs capteurs infrarouges ou de température (120, 125) et stockant des instructions lisibles par machine qui, lorsqu'elles sont exécutées, amènent les un ou plusieurs processeurs (132) à réaliser au moins ce qui suit :
recevoir les données de température générées par les un ou plusieurs capteurs infrarouges ou de température (120, 125) ;
déterminer la quantité de courant traversant les un ou plusieurs composants cibles sur la base des données de courant collectées par les un ou plusieurs capteurs de courant (127)
déterminer un courant nominal pour les un ou plusieurs composants cibles ;
comparer les données de température à un seuil de température spécifique, dans lequel le seuil de température spécifique est basé sur la quantité de courant traversant les un ou plusieurs composants cibles et le courant nominal ; et
contrôler les un ou plusieurs capteurs infrarouges ou de température (120, 125) sur la base des données de température et du seuil de température spécifique.

2. Système (100) selon la revendication 1, dans lequel les instructions lisibles par machine amènent en outre les un ou plusieurs processeurs (132) à :
comparer les données de température au seuil de température spécifique ; et
en réponse à la détermination que les données de température se rapportant aux un ou plusieurs composants cibles sont en deçà du seuil de température spécifique, continuer à recevoir les données de température générées par les un ou plusieurs capteurs infrarouges ou de température (120, 125).

3. Système (100) selon la revendication 2, dans lequel les instructions lisibles par machine amènent en outre les un ou plusieurs processeurs (132) à :
en réponse à la détermination que les données de température se rapportant aux un ou plusieurs composants cibles passent en dessous du seuil de température spécifique, la détermination d'au moins une action ; et
la réalisation d'au moins une action.

4. Système (100) selon la revendication 3, dans lequel l'au moins une action inclut au moins l'une parmi une action corrective, la transmission d'une alerte, la gestion du fonctionnement de divers composants, l'indication d'un emplacement spécifique où une anomalie de température est repérée sur une interface utilisateur, et la fourniture d'instructions pour corriger l'anomalie de température.

5. Système (100) selon la revendication 1 comprenant :
un ou plusieurs capteurs infrarouges et un ou plusieurs capteurs de température (120, 125) couplés en communication aux un ou plusieurs processeurs (132), dans lequel les un ou plusieurs capteurs infrarouges et les un ou plusieurs capteurs de température (120, 125) sont positionnés pour détecter la quantité d'énergie thermique émise par les un ou plusieurs composants cibles du système d'alimentation électrique.

6. Système (100) selon la revendication 1, comprenant en outre :
un moniteur (302) couplé en communication aux un ou plusieurs processeurs (132), dans lequel les un ou plusieurs capteurs infrarouges ou de température (120, 125) comprennent une ou plusieurs caméras infrarouges.

7. Système (100) selon la revendication 6, dans lequel les instructions lisibles par machine amènent en outre les un ou plusieurs processeurs (132) à :
recevoir des données d'image générées par les une ou plusieurs caméras infrarouges ; et
afficher une ou plusieurs images thermiques représentatives des un ou plusieurs composants cibles et un environnement entourant les un ou plusieurs composants cibles sur le moniteur (302), dans lequel les une ou plusieurs images thermiques sont basées sur les données d'image.

8. Procédé de surveillance continue d'une température d'un ou plusieurs composants d'un système d'alimentation électrique, le procédé comprenant :
la réception des données de température générées par un ou plusieurs capteurs infrarouges ou de température (120, 125) par un dispositif informatique (130), dans lequel une quantité d'énergie thermique émise par les un ou plusieurs composants cibles du système d'alimentation électrique est détectée par un ou plusieurs capteurs infrarouges ou de température (120, 125)
la détermination, par le dispositif informatique (130), de la quantité de courant traversant les un ou plusieurs composants cibles sur la base des données de courant collectées par un ou plusieurs capteurs de courant (127) positionnés pour détecter une quantité de courant traversant les un ou plusieurs composants cibles ;
la détermination d'un courant nominal pour les un ou plusieurs composants cibles ;
la comparaison des données de température à un seuil de température spécifique, dans lequel le seuil de température spécifique est basé sur la quantité de courant traversant les un ou plusieurs composants cibles et le courant nominal ; et
le contrôle, par le dispositif informatique (130), des un ou plusieurs capteurs infrarouges ou de température (120, 125) sur la base des données de température et du seuil de température spécifique.

9. Procédé selon la revendication 8, comprenant en outre :
la comparaison des données de température au seuil de température spécifique ;
en réponse à la détermination que les données de température se rapportant aux un ou plusieurs composants cibles sont en deçà du seuil de température spécifique, la poursuite de la réception des données de température générées par les un ou plusieurs capteurs infrarouges ou de température (120, 125) ; et
en réponse à la détermination que les données de température se rapportant aux un ou plusieurs composants cibles passent en dessous du seuil de température spécifique, la détermination d'au moins une action.
